# EUROPÄISCHE PATENTSCHRIFT

(11) **EP 2 504 470 B1**
(45) Veröffentlichungstag und Bekanntmachung des Hinweises auf die Patenterteilung: **27.11.2013**
(21) Anmeldenummer: 10801372.3
(22) Anmeldetag: 23.11.2010
(51) Int. Cl.: C30B 15/10, C30B 15/14, C30B 29/06

(54) **VERFAHREN UND VORRICHTUNG ZUR HERSTELLUNG VON EINKRISTALLEN AUS HALBLEITERMATERIAL**
PROCESS AND APPARATUS FOR PRODUCING SEMICONDUCTOR SINGLE CRYSTALS
PROCEDE ET APPAREIL POUR LA PRODUCTION DES MONOCRISTAUX SEMICONDUCTEURS

(30) Priorität: 24.11.2009 DE 102009056125
(43) Veröffentlichungstag der Anmeldung: 03.10.2012
(73) Patentinhaber: Forschungsverbund Berlin E.V., 12483 Berlin (DE)
(72) Erfinder: RIEMANN, Helge, 15732 Schulzendorf (DE); ABROSIMOV, Nikolai, V., 12555 Berlin (DE); FISCHER, Jörg, 12623 Berlin (DE); RENNER, Matthias, 15713 Königs Wusterhausen (DE)
(74) Vertreter: Hoffmann, Heinz-Dietrich
(86) Internationale Anmeldenummer: PCT/DE2010/001371
(87) Internationale Veröffentlichungsnummer: WO 2011/063795

(56) Entgegenhaltungen:
- CA-A- 713 524
- DE-A1- 2 416 489
- DE-A1- 3 519 632
- DE-A1- 4 318 184
- US-A- 4 133 969

## Beschreibung

Die Erfindung betrifft ein Verfahren und eine Vorrichtung zur Herstellung von Einkristallen aus Halbleitermaterial. Dabei wird ein monokristalliner Impfkristall in die Schmelzenoberfläche getaucht, teilweise angeschmolzen und kontrolliert in vertikaler Richtung bewegt, wodurch ein Einkristall heranwächst. Dieser grundsätzliche Herstellungsprozess des einkristallinen Siliziums ist unabhängig von seiner Verwendung z.B. in der Elektronik- bzw. der Solarindustrie fast identisch.

Durch den stark angestiegenen und weiter steigenden Bedarf an einkristallinem Silizium als Ausgangsmaterial von Solarzellen und für die Elektronik werden Verfahren entwickelt, mit denen Einkristalle mit möglichst wenig Verunreinigungen und großen Abmessungen kostengünstig hergestellt werden können. So sind verschiedene Verfahren zur Herstellung solcher Einkristalle üblich und beschrieben worden.

Ein übliches und verbreitetes Standardverfahren zur Herstellung von Einkristallen ist das Czochralski-Verfahren, bei dem das zu einem Einkristall zu ziehende Halbleitermaterial in einem Quarztiegel zum Schmelzen gebracht wird und aus dieser Schmelze der Kristall nach oben gezogen wird. Die wesentlichen Nachteile dieses Verfahrens bestehen darin, dass die Schmelze in jedem Fall den Tiegel anlöst, wodurch die Schmelze und damit der Kristall verunreinigt wird, und der Quarztiegel nach einer relativ kurzen Standzeit erneuert werden muss. Es gibt auch Lösungen, um mit aufwändigen Methoden für den Quarztiegel eine größere Standzeit zu erreichen wie es in der DE 102 17 946 A1 beschrieben ist. Jedoch wird in jedem Fall nur ein Kristall mit CZ- typischen Verunreinigungen gezogen, die zusätzlich axial inhomogen verteilt sind.

In der DE 24 16 489 wird ein Verfahren zur Züchtung von versetzungsarmen bzw. versetzungsfreien Einkristallen aus Silizium nach dem Czochralski-Verfahren beschrieben, bei dem die Nachteile des Czochralski-Verfahrens dadurch ausgeschaltet werden sollen, dass anstelle eines Tiegels, analog zum Pedestalverfahren, ein angeschmolzener Vorratsstab als Materialquelle verwendet wird. Bei Verwendung eines Induktors als Heizquelle und geeigneter Wahl der Frequenz des den Induktor durchfließenden Wechselstromes wird infolge der Stromverdrängung in Kombination mit den lateralen Wärmeverluste an der Oberfläche des Vorratsstabs eine feste Randschicht nicht aufgeschmolzen, die somit ein Gefäß für die Schmelze darstellt und damit ein von artfremden Tiegelwerkstoffen freies Kristallziehen ähnlich dem Pedestal- Verfahren ermöglicht. Ein wesentlicher Nachteil dieser Lösung besteht darin, dass nur Kristalle gezogen werden können, die einen wesentlich kleineren Durchmesser aufweisen als der Vorratsstab. Außerdem muss bei dieser Lösung der nicht schmelzende Rand des Vorratsstabs wegen der relativ guten Leitfähigkeit des massiven Materials zu seiner Stabilisierung viel Wärme abgeben, die durch die induktive Energiezufuhr ausgeglichen werden muss.

Auch bei dem in der DE 44 47 398 beschriebenen Verfahren sollen die Nachteile des Czochralski-Verfahrens ausgeschaltet werden. Dazu ist vorgesehen, dass das im Tiegel befindliche Halbleiter-Material zunächst durch eine Induktionsspule geschmolzen wird. Dadurch entsteht zunächst Schmelze, die den Tiegel ausfüllt. Die Heizleistung wird danach soweit gesenkt, dass sich eine stabile feste Schicht an der Tiegelinnenwand ausbildet. Die erstarrte Randschicht ist in ihrer Funktion eine Passivierungsschicht und sorgt zusätzlich als Bodenkörper für eine Selbststabilisierung der Temperatur in der Schmelze. Während der Phase der Überhitzung der Schmelze kommt diese mit der Außenwand des Tiegels in Reaktion, wobei Sauerstoff und andere Verunreinigungen in die Schmelze gelangen. Wie beim vorangegangenen Beispiel muss auch bei dieser Lösung viel Energie in den Randbereichen an die kühlere Umgebung abgegeben werden, um auch hier die feste Randschicht zu stabilisieren. Dass Volumen der mit der vorgeschlagenen Vorrichtung herzustellenden Kristalle ist begrenzt, da wegen fehlender Möglichkeiten der Überhitzung der Schmelze eine Nachchargierung mit festem Si nicht möglich ist und eine Nachchargierung mit flüssigem Silizium mit Fremdstoffeintrag verbunden wäre.

Ein weiteres Verfahren ist das Floating Zone (FZ)-Verfahren, mit dem hochreine Si-Einkristalle gezogen werden können. In der DE 30 07 377 A1 sind die Grundzüge des FZ-Verfahrens beschrieben. Nachteilig sind hier der begrenzte Durchmesser und die hohen Herstellungskosten geeigneter polykristalliner Rohstäbe.

Ein drittes Verfahren zur Herstellung von Einkristallen ist das ebenfalls tiegelfreie Pedestalverfahren. Ein polykristalliner Stab wird durch einen Induktor an seiner gesamten oberen Stirnseite aufgeschmolzen. Die aufgeschmolzene Zone wird durch die Öffnung des Induktors mit einem Impfkristall in Berührung gebracht und der wachsende Einkristall, im Unterschied zum Zonenschmelzverfahren, nach oben gezogen. Wesentlicher Nachteil des Pedestalverfahrens ist, dass der Durchmesser des gezogenen Kristalls immer deutlich kleiner als der der Induktoröffnung der des Rohstabs ist.

Die wesentlichen Verfahrensschritte und Vorrichtungsmerkmale, die für das Pedestalverfahren charakteristisch sind, werden in der DE 21 10 882 A1 beschrieben. Ein polykristalliner Stab, der aus dem Halbleitermaterial besteht, wird an seiner Kuppe durch eine Heizung aufgeschmolzen, aus der dann ein Einkristall gezogen wird.

Ein weiteres Beispiel zum Ziehen eines Einkristalls nach dem Pedestalverfahren ist in der CA 713524 A detailliert dargestellt.

Auch in der US 2,961,305 A ist eine Lösung zum Ziehen eines Einkristalls nach dem Pedestalverfahren beschrieben worden.

Der wesentliche Nachteil des klassischen Pedestalverfahrens besteht darin, dass der gezogene Einkristall immer einen geringeren Durchmesser aufweist als der verwendete Rohstab. Der Rohstab wiederum hat einen begrenzten Durchmesser, der durch das Siemens-Verfahren zur Herstellung des Siliziums vorgegeben ist. Besonders für einen großen Kristalldurchmesser wird dessen Verhältnis zum Vorratsstabdurchmesser aus wärmetechnischen Gründen immer ungünstiger. Um diese Nachteile zu vermeiden sind weitere Lösungen bekannt, die das Pedestalverfahren verwenden.

So ist in der DE 35 19 632 A1 ein Verfahren und eine Vorrichtung zum Ziehen von monokristallinen Siliziumstäben beschrieben, bei dem ein SiliziumGranulat in ein Gefäß gefüllt wird, in dem ein Schmelzensee an der Oberfläche erzeugt werden soll, aus dem dann der Einkristall gezogen werden kann. Zur Erzeugung des Schmelzensees ist vorgesehen, dass durch den Stromfluss zwischen zwei Siliziumelektroden die in das Granulat hineinreichen das Granulat so weit erhitzt wird, bis es einen Schmelzensee bildet. Dieses Verfahren lässt sich aber praktisch nicht realisieren, da die Elektroden, die aus Silizium gefertigt sein müssen, um die entstehende Schmelze und damit den zu ziehenden Kristall nicht zu verunreinigen, bei der Schmelztemperatur einen ca. 30 mal so hohen spezifischen elektrischen Widerstand haben wie die entstehende Schmelze. Somit werden pro Volumeneinheit nur ca. 3 % der zugeführten Elektroenergie im Schmelzensee in Wärme umgesetzt, während die übrigen ca. 97 % der elektrischen Energie in den festen Siliziumelektroden freigesetzt werden müssten, was dazu führen würde, dass diese entweder selbst schmelzen würden oder aber die Schmelze erstarren würde.

Ein anderes Beispiel ist in der DE 35 25 177 A1 dargestellt. Hier werden die Siliziumelektroden in Bohrungen eingeführt, die in einen massiven Siliziumblock eingebracht sind. Durch Aufheizen der Siliziumelektroden und Kühlen des Siliziumblocks soll erreicht werden, dass zwischen zwei Siliziumelektroden ein Lichtbogen erzeugt wird, der durch eine dritte Siliziumelektrode gezündet wird. Der Nachteil dieser Lösung besteht insbesondere darin, dass die Elektroden zusätzlich beheizt werden müssen und der Siliziumblock gekühlt werden muss. Weiterhin ist es praktisch zweifelhaft, dass bei der vorgestellten Anordnung tatsächlich durch die beiden Elektroden ein solcher Schmelzensee gebildet wird, aus dem dann ein Siliziumeinkristall gezogen werden kann. Es gilt auch hier das bereits zu der DE 35 19 632 A1 beschrieben Energieproblem.

In der DE 43 18 184 A1 ist ein Verfahren und eine Vorrichtung zum Ziehen von Einkristallen aus einer Schmelze beschrieben worden. Das Verfahren sieht vor, dass ein monokristalliner Impfkristall zu einem Einkristall heranwächst, indem der Impfkristall in die Schmelze getaucht und kontrolliert in vertikaler Richtung zur Schmelze angehoben wird. Die Schmelze bildet einen Schmelzensee, der nur von der Oberflächenspannung und von elektromagnetischen Kräften einer Induktionsspule auf einem massiven Trägerkörper gehalten wird, der aus dem Halbleitermaterial hergestellt ist. Während des Wachstums des Einkristalls wird Halbleitermaterial in fester oder flüssiger Form zur Schmelze nachchargiert. Durch eine zusätzliche Beheizung des Trägerkörpers wird die Induktionsspule, die als Heizquelle der Erzeugung und/oder Aufrechterhaltung des Schmelzsees dient, wirksam unterstützt und es können damit Wärmeverluste ausgeglichen werden, die zwangsläufig beim Nachchargieren des Halbleitermaterials auftreten. Die Induktionsspule ist vorzugsweise flächig ausgebildet und befindet sich oberhalb des Trägerkörpers. Der Abstand zu diesem ist veränderbar. Der Schmelzsee ruht auf dem Trägerkörper, der über eine Widerstandsheizung, die als zusätzliche Heizquelle in einem Hohlraum des Trägerkörpers angeordnet ist, beheizt werden kann. Vorzugsweise ist der Trägerkörper nicht aus einem Stück geformt, sondern aus mehreren Segmenten zusammengesetzt. Durch eine geeignete Formgebung der einzelnen Segmente wurde im Trägerkörper ein Hohlraum geschaffen, der zur Aufnahme der zusätzlichen Widerstandsheizung dient.

Der Nachteil dieser Lösung besteht insbesondere darin, dass der Trägerkörper aus Silizium sehr aufwändig gefertigt werden muss und dieser Trägerkörper nach Beendigung des Ziehprozesses durch erneute mechanische Bearbeitung wieder in seinen Ausgangszustand zurückversetzt werden müsste. Außerdem entsteht durch die Widerstandsheizung ein erheblicher zusätzlicher Energiebedarf. Da der Trägerkörper aus massivem Silizium gefertigt ist sind zusätzliche Maßnahmen erforderlich, um einen Temperaturgradienten zwischen Widerstandsheizung und Schmelzensee aufrecht zu erhalten, damit gleichzeitig das Schmelzenvolumen und der Trägerkörper selbst stabil bleiben.

Die Aufgabe der Erfindung besteht darin, ein Verfahren und eine Vorrichtung anzugeben mit denen Einkristalle mit den Materialeigenschaften des FZ-Verfahrens in einem kontinuierlichen Prozess kostengünstig hergestellt werden können, deren Durchmesser und Längen nicht prinzipiell eingeschränkt sind. Dabei soll ein Tiegel aus Eigenmaterial, das sich in einem einfachen Gefäß befindet, zur Bereitstellung der Halbleiterschmelze erzeugt werden. Es sollen keine Elektroden bzw. Widerstandsheizungen für die Energiezufuhr zum Einsatz kommen. Das Verfahren soll eine günstige Energiebilanz und nur geringe Energieverluste aufweisen.

Diese Aufgabe wird durch das erfindungsgemäße Verfahren realisiert, das durch die Merkmale des Patentanspruchs 1 gekennzeichnet ist. Dabei wird ein Einkristall aus einer Schmelze gezogen, die einen Schmelzensee an der Oberfläche eines Halbleitermaterials bildet. Der Einkristall wird an einem Impfkristall durch die Zentralöffnung eines Induktors gezogen. Der Induktor wird dem bekannten Stand der Technik entsprechend aus einer flachen Scheibe gebildet. Das Halbleitermaterial, auf dem sich der Schmelzensee ausbildet, befindet sich in Form einer körnigen Schüttung in einem für hochfrequente Magnetfelder durchlässigen Gefäß. Dieses körnige Halbleitermaterial bildet quasi einen "Eigentiegel" für den Schmelzensee aus, so dass dieser "Eigentiegel" aus dem gleichen Material wie die Schmelze besteht. Bei dem erfindungsgemäßen Verfahren wird der physikalische Effekt ausgenutzt, der in der besonders geringen thermischen und elektrischen Leitfähigkeit des lockeren Granulats, verglichen mit der kompakten festen Zwischenschicht und der Schmelze besteht. Das Granulat weist auf Grund der Zwischenräume und lediglich punktuellen Verbindung zwischen den einzelnen Körnern eine sehr geringe elektrische Leitfähigkeit auf, wodurch im Granulat keine relevanten Wirbelströme induziert werden. Dadurch wird das Granulat durch den Induktor nur geringfügig erwärmt. In der Schmelze, die hier die größte Leitfähigkeit aufweist, bilden sich starke induktive Wirbelströme aus, so dass hier auch der größte Leistungseintrag stattfindet und somit die höchsten Temperaturen erzeugt werden bis hin zur lokalen Überhitzung an der freien Oberfläche. Da das körnige Halbleitermaterial auch ein schlechter thermischer Leiter ist, wird gewährleistet, dass die Größe des Schmelzensees mit dem oberhalb des Schmelzensees angeordneten Induktor gesteuert werden kann. Außerdem ist somit gewährleistet, dass die Schmelze nicht mit dem Gefäß in Berührung kommt, wodurch deren Reinheit gewahrt werden kann, ohne dass an das Gefäß besondere Reinheitsforderungen zu stellen wären.

Aus vorgenannten Gründen, werden zur Erzeugung der Temperatur im Schmelzensee ausschließlich induktive Heizungen verwendet.

Der Schmelzensee, der von der körnigen Schüttung umgeben ist, wird hauptsächlich durch die Energie des oberhalb dessen Oberfläche angeordneten Induktors erzeugt, der mit einer Hochfrequenz von ca. 1 bis 4 MHz gespeist wird. Durch den Abstand des Induktors von der Oberfläche und durch den eingespeisten HF-Strom kann die Größe und Tiefe des Schmelzensees gut gesteuert werden. Die Form dieses Induktors ist so gewählt, dass seine induzierte Leistungsverteilung einen Schmelzensee erzeugt, dessen Tiefe mindestens 20% seines Durchmessers beträgt und dessen freie Oberfläche lateral um mindestens 5-10 mm weiter ausgedehnt ist als der Induktorgrundriss. Der Induktor weist eine Zentralöffnung auf, die dem gewünschten Kristallquerschnitt entspricht. Mit einem einwindigen Induktor, der einen Hauptschlitz und eine runde Zentralöffnung aufweist, wird z.B. eine nahezu rotationssymmetrische Temperaturverteilung erzeugt, so dass ein nahezu runder Schmelzensee erzeugt wird und ein Kristall mit rundem Querschnitt aus der Zentralöffnung gezogen wird.

Das Ziehen eines runden Kristalls wird vorzugsweise dadurch unterstützt, dass die Ziehvorrichtung mit dem wachsenden Kristall um seine Achse rotiert.

Durch die Wahl anderer Induktorformen, z. B. mit Zentralöffnungen von rechteckiger bzw. polygonaler Form auch kombiniert mit Nebenschlitzen, wird eine entsprechend geometrisch geänderte Temperaturverteilung erzeugt, die günstig für das Wachstum von Kristallen mit rechteckigem bzw. polygonalem Querschnitt wirkt, wobei für diese Fälle grundsätzlich die Kristallrotation anzuhalten ist. Die laterale Ausdehnung des Induktors. übersteigt den Kristallquerschnitt an allen Außenkanten um mehr als 20- 30mm und beträgt vorzugsweise das 1,5 - 2 fache des Kristallquerschnittes

Es ist von Vorteil, das Gefäß langsam um seine Achse zu rotieren, um einen runden Schmelzensee und ein gleichmäßiges Schmelzen des nachchargierten Materials zu gewährleisten.

Damit für große Kristallquerschnitte der Schmelzensee im Zentrum ausreichend tief ist und damit beim Nachchargieren von körnigem Halbleitermaterial genug Schmelzwärme zugeführt werden kann, ist eine zusätzliche Induktionsheizung vorgesehen, die überwiegend von unten den Schmelzensee beheizt, wiederum ohne dabei dem Granulat nennenswert Energie zuzuführen. Diese Induktionsheizung ist in Form einer Spule ausgestaltet, die mit einem Hochfrequenzstrom geringerer Frequenz von ca. 5 bis 500 kHz gespeist wird und deren Windungen um das Gefäß herum angeordnet sind. Durch die frequenzbedingte große Eindringtiefe und die Wahl der Anordnung der Induktionsspule wird Wärmeenergie bevorzugt am Grenzbereich zwischen dem körnigen Halbleitermaterial und der Schmelze induziert. Gleichzeitig wird ein solcher Temperaturgradient zwischen Gefäßwand und Schmelzensee gezielt eingestellt, dass das Halbleitermaterial in der Umgebung der ungeheizten Gefäßwand stabil bleibt, d. h. einen ausreichenden thermischen und elektrischen Widerstand aufweist. Somit wird gewährleistet, dass die Schmelze aus der der Einkristall gezogen wird, nicht mit der Gefäßwand in Berührung kommt und aus dieser keine Stoffe herausgelöst werden können, die die Schmelze verunreinigen würden. Zur Realisierung eines optimal gestalteten Schmelzensees kann es von Vorteil sein, einen weiteren, vorzugsweise flachen Induktor unmittelbar unter dem Gefäß anzuordnen. Alternativ können die beiden weiteren Induktoren, die um das Gefäß herum und unter dem Boden des Gefäßes angeordnet sind, als eine Spule zusammengeschaltet werden.

Vorteilhafterweise besteht das körnige Halbleitermaterial aus gebrochenen Stücken bzw. aus Wirbelschicht- Granulat. Die bevorzugte Korngröße beträgt ca. 0,01 mm bis 20 mm.

Die erfindungsgemäße Vorrichtung zur Durchführung des vorgenannten Verfahrens wird durch die Merkmale des Anspruchs 11 charakterisiert. Es wird dabei eine Vorrichtung verwendet, die grundsätzlich den bekannten Vorrichtungen zur Durchführung eines Pedestalverfahrens ähnelt. Oberhalb des Gefäßes, in dem sich das körnige Halbleitermaterial befindet auf dem der Schmelzensee erzeugt wird, ist ein scheibenförmiger einwindiger Induktor angeordnet, durch dessen Zentralöffnung der Einkristall gezogen wird. Der Querschnitt der Zentralöffnung wird entsprechend des Querschnittes des zu ziehenden Kristalls dimensioniert. Ein Kristall mit rundem Querschnitt wird aus einer runden Zentralöffnung gezogen. Zentralöffnungen mit rechteckigem bzw. polygonalem Querschnitt, auch kombiniert mit Nebenschlitzen, erzeugen eine entsprechend geometrisch geänderte Temperaturverteilungen, die günstig für das Wachstum von Kristallen mit rechteckigem bzw. polygonalem Querschnitt sind. Oberhalb des Induktors befindet sich eine übliche Ziehvorrichtung mit dem daran befestigten Impfkristall. Das Gefäß weist einen solchen Durchmesser und eine solche Höhe auf, dass zwischen Gefäßwand und Schmelzensee in allen Richtungen mindestens eine ausreichende Dicke von ungeschmolzenen Halbleitermaterial vorhanden ist. Der so entstehende "Eigentiegel" weist eine Wandstärke von einigen Zentimetern auf. Das Gefäß besteht aus einem elektrisch isolierenden und temperaturbeständigen sowie für hochfrequente Magnetfelder durchlässigen Material. An das Material des Gefäßes werden keine besonderen Anforderungen hinsichtlich der Reinheit oder chemischen bzw. mechanischen/thermischen Stabilität gestellt. Als Gefäß eignet sich beispielsweise Quarzglas. In der vertikalen Richtung muss das Gefäß nicht bewegbar sein. Der scheibenförmige Induktor oberhalb des Gefäßes ist in vertikaler Richtung gegenüber dem Gefäß beweglich ausgeführt.

Die um das Gefäß angeordnete Induktionsspule weist ca. 3-5 Windungen auf, die etwa in Höhe des Schmelzensees mit einem mit einem Abstand von ≤ 5 mm zur Außenwand des Gefäßes angeordnet ist. Die unter dem Gefäß angeordnete Induktionsspule weist ebenfalls einen Abstand von ≤ 5 mm zum Boden des Gefäßes auf.

Zum Nachchargieren von körnigem Halbleitermaterial ist eine Zuführung vorgesehen, die durch eine zusätzliche Öffnung im Induktor in das Gefäß geführt ist, so dass das nachchargierte Halbleitermaterial auf den Rand des Schmelzensees nachgefüllt wird, damit einerseits dessen Pegel konstant bleibt und andererseits die Granulatkörner schmelzen, bevor sie schwimmend zur Kristallisationsphasengrenze gelangen können. Letzteres würde zum Verlust der Einkristallinität führen.

Sollte die Granulatqualität nicht für Einkristallzüchtung ausreichen, können alternativ mit diesem Verfahren auch polykristalline Halbleiterstäbe z.B. als Rohstäbe für eine nachfolgende FZ Kristallzüchtung gezogen werden. Weitere vorteilhafte Ausgestaltungen können den Unteransprüchen entnommen werden.

Die Vorteile des erfindungsgemäßen Verfahrens bestehen darin, dass ein Einkristall mit den Materialeigenschaften eines zonengezogenen Einkristalls in einem kontinuierlichen Prozess gezogen werden kann, dessen Querschnitt grundsätzlich nicht vom Rohmaterial bestimmt wird, wie es beim FZ- und beim Pedestalverfahren der Fall ist. Sein Querschnitt wird prinzipiell begrenzt vom Querschnitt der Zentralöffnung des verwendeten Induktors. Seine Länge wird insbesondere begrenzt durch die Größe der gasdichten Züchtungskammer der Anlage, in der die erfindungsgemäße Vorrichtung angeordnet ist sowie dem Fahrweg der verwendeten Ziehvorrichtung. Das verwendete Gefäß für die Aufnahme des körnigen Halbleitermaterials muss aus elektrisch isolierendem, unmagnetischen Material bestehen z.B. aus kostengünstigem Quarzglas, da es nicht in Kontakt mit der Schmelze kommt und grundsätzlich nicht verschleißt. Das Halbleitermaterial kann in Form von preiswertem Granulat oder körnigem Bruch eingesetzt werden. Die Energiebilanz des erfindungsgemäßen Verfahrens ist günstiger als bei den vergleichbaren Verfahren nach dem bekannten Stand der Technik.

Das erfindungsgemäße Verfahren sowie die Vorrichtung zur Durchführung dieses Verfahrens werden nachfolgend an Hand eines Ausführungsbeispiels näher erläutert. Im gewählten Beispiel soll ein Siliziumkristall mit einem Durchmesser von ca. 50 mm gezogen werden.

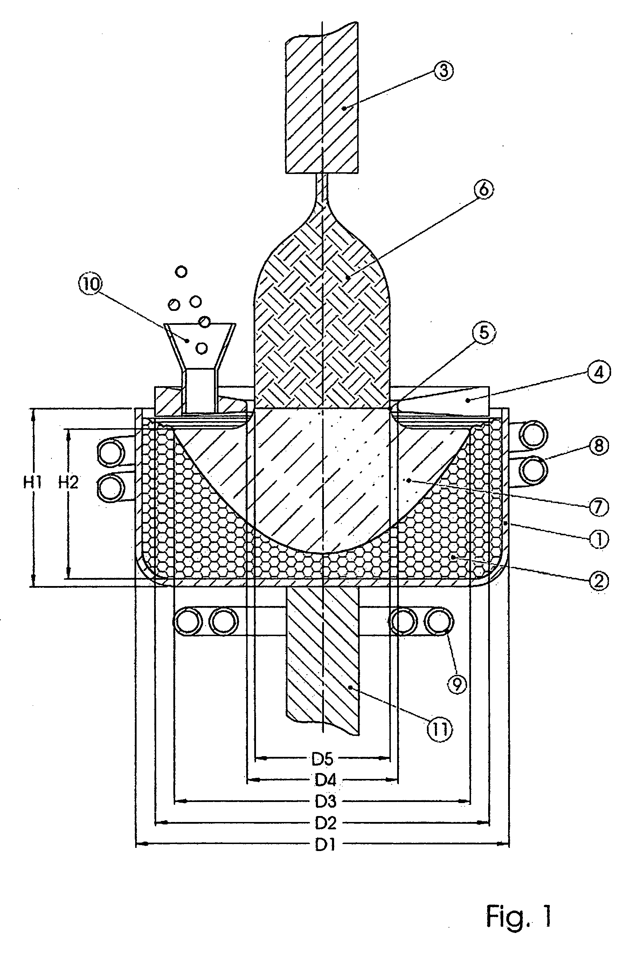

- Fig. 1:: Schematische Seitenansicht der erfindungsgemäßen Vorrichtung

Die zugehörige Zeichnung, Fig. 1 zeigt eine schematische Seitenansicht der erfindungsgemäßen Vorrichtung, mit der das erfindungsgemäße Verfahren durchgeführt wird. Die gezeigte Vorrichtung ist in der nicht dargestellten gasdichten Züchtungskammer einer FZ- Anlage untergebracht, die mit Argon gefüllt ist. Im gewählten Beispiel soll ein Einkristall mit rundem Querschnitt gezogen werden. Das Gefäß 1, in dem sich das Ausgangsmaterial zur Herstellung des Siliziumkristalls in Form von Siliziumgranulat **2** befindet, ist auf einer unteren Ziehspindel **11** der FZ-Anlage angeordnet. Das verwendete Gefäß **1** besteht aus Standardquarzglas und hat einen Durchmesser **D1** von ca. 20 cm sowie eine Höhe **H1** von ca. 10 cm. Das Gefäß **1** ist im gewählten Beispiel mit dem Siliziumgranulat **2** bis zu einer Höhe von ca. 9 cm gefüllt. Die Korngröße des Siliziumgranulats **2** beträgt ca. 0,3 - 3 mm.

Oberhalb des Gefäßes **1** ist über dem Siliziumgranulat **2** ein einwindiger scheibenförmig ausgebildeter runder Induktor **4** angeordnet, der eine runde Zentralöffnung **5** und einen Hauptschlitz aufweist, an den die beiden Stromzuführungen angeschlossen sind. Der Durchmesser **D2** des Induktors **4** ist kleiner als der Durchmesser **D1** des Gefäßes **1,** damit er dicht an die Oberfläche der Schüttung positioniert werden kann. Der Durchmesser **D4** der runden Zentralöffnung **5** des Induktors **4** beträgt im gewählten Beispiel ca. 60 mm. Somit kann ein Kristall **6** mit einem Durchmesser **D5** von ca. 50 mm gezogen werden. Der Induktor **4** wird von einem HF-Strom mit einer Frequenz von ca. 3 MHz bei einer Generatorleistung von ca. 25 kW durchflossen. Dieser Induktor **4** erzeugt ein rotationssymmetrisches Temperaturfeld wodurch ein runder Schmelzensee **7** aufrechterhalten wird. Der Durchmesser **D3** des Schmelzensees **7** beträgt im gewählten Beispiel ca. 120 mm. Oberhalb des Induktors **4** befindet sich die obere Ziehspindel **3**, die den Keimkristall und später den wachsenden Einkristall **6,** trägt und nach oben aus der Schmelze zieht.

Um das Gefäß 1 herum ist ein weiterer Induktor **8** angeordnet, der als mehrwindige Induktionsspule ausgebildet ist. Die Windungszahl beträgt ca. 4 Windungen und der Abstand der Windungen zur Außenwand des Gefäßes **1** beträgt ca. 3 mm. Die Induktionsspule **8** weist eine Höhe von ca. 30 mm auf und ist im oberen Bereich des Gefäßes angeordnet. Sie wird von einem HF-Strom mit einer Frequenz von ca. 10 kHz und einer Leistung von ca. 3 kW durchflossen. Das von dem zylindrischen Induktor **8** erzeugte Temperaturfeld bewirkt, dass zentral unter dem Schmelzensee **7** das Siliziumgranulat **2** auf Schmelztemperatur von ca. 1412 °C gehalten wird. Im Siliziumgranulat **2** wird auf Grund seines hohen elektrischen und thermischen Widerstandes ein solcher Temperaturgradient bewirkt, dass an der Innenwand des Gefäßes **1** eine Temperatur von maximal ca. 500 °C besteht. Da das Siliziumgranulat **2** die geforderte Reinheit aufweist und die Schmelze nur mit dem Siliziumgranulat **2** in Berührung kommt und nicht mit der Gehäusewand, gelangen von dieser praktisch keine Verunreinigungen in die Schmelze und den gezogenen Einkristall **6.** Deshalb spricht man bei dieser Anordnung auch von einem "Eigentiegel", da der Tiegel durch arteigenes Halbleitermaterial gebildet wird.

Die erfindungsgemäße Vorrichtung weist im gewählten Beispiel einen zusätzlichen Induktor **9** auf, der unterhalb des Gefäßes **1** angeordnet ist. Dieser weitere Induktor **9** ist vorzugsweise als mehrwindige, spiralförmig ebene Induktionsspule ausgebildet. Durch diesen zusätzlichen Induktor **9** wird bewirkt, dass die Größe und besonders die Tiefe des Schmelzensees **7** durch Einwirkung auf die Grenzfläche zur Siliziumgranulat- Schüttung **2** optimal gesteuert werden kann.

Durch eine Nachchargiereinrichtung **10** wird kontinuierlich, in Abhängigkeit von der Ziehgeschwindigkeit und dem Durchmesser **D5** des Kristalls **6** durch eine zusätzliche Öffnung im Induktor **4** so viel Granulat **2** nachchargiert, dass der Pegel **H2** des Schmelzensees **7** stets konstant bleibt. Dadurch wird gewährleistet, dass der Kristall **6** kontinuierlich gezogen werden kann ohne dass das Material aus der Schüttung bzw. der Eigentiegel verbraucht wird. Das Gefäß **1** wird mit der unteren Ziehspindel **11** mit ca. 3 Umdrehungen pro Minute um seine Achse rotiert. Somit wird ein gleichmäßiges Schmelzen des nachchargierten Materials gewährleistet, um stets einen runden Schmelzensee **7** aufrecht zu erhalten und zu verhindern, dass unvollständig geschmolzenes Granulat **2** an die Wachstumsgrenze des Kristalls **6** gelangen kann.

Wenn der Kristall **6** die vorgesehene Länge erreicht hat, die durch die Abmessungen der Ziehvorrichtung begrenzt ist, wird er von der Schmelze abgezogen, wobei nach Abschalten der Ströme durch den Induktor **4** sowie die Induktionsspule **8** und gegebenenfalls die Induktionsspule **9** das im Schmelzensee verbliebene Halbleitermaterial **7** erstarrt.

Ist die Vorrichtung für einen neuen Ziehprozess vorbereitet, kann nach einem Vorheizen der erstarrte Schmelzensee **7** induktiv wieder aufgeschmolzen und nach Wiederherstellung des Schmelzenniveaus und Animpfen eines Keimkristalls ein neuer Ziehprozess begonnen werden.

### Aufstellung der verwendeten Bezugszeichen

- 1: Gefäß
- 2: Siliziumgranulat
- 3: obere Ziehspindel
- 4: einwindiger scheibenförmiger Induktor
- 5: Zentralöffnung des Induktors 4
- 6: Kristall
- 7: Schmelzensee
- 8: mehrwindiger zylindrischer Induktor
- 9: mehrwindiger flacher Induktor
- 10: Nachchargiereinrichtung
- 11: untere Ziehspindel
- D1: Gefäßdurchmesser
- D2: Durchmesser des Induktors 4
- D3: Durchmesser des Schmelzensees
- D4: Durchmesser der Zentralöffnung des Induktors 4
- D5: Kristalldurchmesser
- H1: Höhe des Gefäßes
- H2: Pegelstand des Schmelzensees

## Patentansprüche

1. Verfahren zur Herstellung von Einkristallen aus Halbleitermaterial mit den Materialeigenschaften eines zonengezogenen Einkristalls, bei dem der Einkristall an einem Impfkristall aus der Schmelze, die sich als Schmelzensee auf einer aus körnigem Halbleitermaterial bestehenden Schüttung befindet, die durch einen von einem HF-Strom durchflossenen flachen Induktor (sog. Pancace-Induktor), der eine Windung und einen Schlitz als Stromzuführung aufweist, erzeugt wird, durch die Zentralöffnung dieses flachen Induktors hindurch nach oben gezogen wird,
**dadurch gekennzeichnet, dass**
sich das körnige Halbleitermaterial (2) in einem für hochfrequente Magnetfelder durchlässigen Gefäß (1) befindet, dessen Wandung nicht mit dem Schmelzensee (7) in Berührung kommt und an der Oberfläche dieser Schüttung (2) durch die thermische Leistungseinkopplung des oberhalb des Gefäßes (1) angeordneten flachen Induktors (4) sowie der Heizwirkung mindestens eines weiteren Induktors (8, 9), der außerhalb des Gefäßes (1) angeordnet ist, ein Temperaturfeld erzeugt wird, das das Entstehen eines offenen und ausreichend tiefen Schmelzensees (7) an der Oberfläche der grobkörnigen Schüttung (2) gewährleistet, der in ungeschmolzenem Halbleitermaterial (2) eingebettet ist.

2. Verfahren nach Anspruch 1,
**dadurch gekennzeichnet, dass**
das körnige Halbleitermaterial (2) eine Korngröße von 0,01 mm bis 20 mm aufweist.

3. Verfahren nach Anspruch 1,
**dadurch gekennzeichnet, dass**
die Zentralöffnung (5) des einwindigen scheibenförmigen Induktors (4) zum Ziehen eines Kristalls (6) mit rundem Querschnitt ebenfalls einen runden Querschnitt aufweist.

4. Verfahren nach Anspruch 1,
**dadurch gekennzeichnet, dass**
zum Ziehen eines runden Kristalls (6) die obere Ziehspindel (3) mit dem wachsenden Kristall (6) um seine Achse rotiert.

5. Verfahren nach Anspruch 1,
**dadurch gekennzeichnet, dass**
zum Ziehen eines Kristalls (6) mit rechteckigem Querschnitt die Zentralöffnung (5) des einwindigen scheibenförmigen Induktors (4) ebenfalls einen rechteckigen Querschnitt aufweist.

6. Verfahren nach Anspruch 1,
**dadurch gekennzeichnet, dass**
zum Ziehen eines Kristalls (6) mit polygonalem Querschnitt die Zentralöffnung (5) des einwindigen scheibenförmigen Induktors (4) einen analogen polygonalen Querschnitt aufweist.

7. Verfahren nach Anspruch 1,
**dadurch gekennzeichnet, dass**
der Hochfrequenzstrom, der durch den flachen Induktor (4) fließt, eine Frequenz zwischen 1 und 4 MHz aufweist.

8. Verfahren nach Anspruch 1,
**dadurch gekennzeichnet, dass**
der Hochfrequenzstrom, der durch die weiteren Induktoren (8, 9) fließt, eine Frequenz zwischen 5 und 500 kHz aufweist.

9. Verfahren nach Anspruch 1,
**dadurch gekennzeichnet, dass**
körniges Halbleitermaterial (2) entsprechend der Ziehgeschwindigkeit des Einkristalls (6) in den Schmelzensee nachchargiert und geschmolzen wird, so dass dessen Pegel (H2) im Gefäß (1) konstant bleibt.

10. Verfahren nach Anspruch 1,
**dadurch gekennzeichnet, dass**
das Gefäß (1) mit dem körnigen Halbleitermaterial (2) um seine Achse rotiert.

11. Vorrichtung zur Herstellung von Einkristallen aus Halbleitermaterial mit den Materialeigenschaften eines zonengezogenen Einkristalls, mit dem Verfahren nach Anspruch 1,
**dadurch gekennzeichnet, dass**
oberhalb eines schüsselförmigen Gefäßes (1), das mit körnigem Halbleitermaterial (2) gefüllt ist, ein flacher scheibenförmig ausgebildeter Induktor (4) angeordnet ist, der einen Hauptschlitz als Stromzuführung und eine Zentralöffnung (5) aufweist, die dem gewünschten Kristallquerschnitt entspricht, durch die der Einkristall (6) mittels einer Ziehvorrichtung (3) nach oben ziehbar ist und dieser scheibenförmige Induktor (4) über eine zusätzliche Öffnung oder Aussparung verfügt, durch die über eine Nachchargiervorrichtung (10) Halbleitermaterial nachfüllbar ist, sowie mindestens ein weiterer Induktor (8, 9), das Gefäß (1) von außen umschließt.

12. Vorrichtung nach Anspruch 11,
**dadurch gekennzeichnet, dass**
die laterale Ausdehnung des flachen scheibenförmig ausgebildeten einwindigen Induktors (4) den Kristallquerschnitt an allen Außenkanten um mehr als 20- 30 mm übersteigt und mindestens das 1,5 - 2 fache des Kristallquerschnittes beträgt.

13. Vorrichtung nach Anspruch 11,
**dadurch gekennzeichnet, dass**
die Zentralöffnung (5) des flachen scheibenförmig ausgebildeten einwindigen Induktors (4) eine dem gewünschten Kristallquerschnitt entsprechenden Form aufweist, die es gestattet den Kristall so durch diese Öffnung hindurch zu ziehen, dass eine Berührung zwischen dem Induktor und dem Kristall oder dem Schmelzmeniskus vermieden wird.

14. Vorrichtung nach Anspruch 11,
**dadurch gekennzeichnet, dass**
mindestens ein weiterer Induktor (8), der als Spule ausgeführt und um das Gefäß herum angeordnet ist.

15. Vorrichtung nach Anspruch 11,
**dadurch gekennzeichnet, dass**
ein zusätzlicher flacher Induktor (9) unter dem Gefäß angeordnet ist.

16. Vorrichtung nach Anspruch 11,
**dadurch gekennzeichnet, dass**
das Gefäß (1) aus einem elektrisch isolierenden temperatur- und abriebbeständigen Material besteht.

17. Vorrichtung nach Anspruch 17,
**dadurch gekennzeichnet, dass**
das Gefäß (1) aus Quarzglas besteht.

## Claims

1. A method for producing single crystals from semiconductor material having the material properties of a zone-pulled single crystal, in which the single crystal on a seed crystal from the melt, which is located as a melt lake on a packed bed consisting of granular semiconductor material, which is produced by a flat inductor (what is known as a pancake inductor) through which an HF current is passed and which has a winding and a slit as current feed, is pulled upwardly through the central opening in this flat inductor,
**characterised in that**
the granular semiconductor material (2) is located in a vessel (1) permeable for high-frequency magnetic fields, the wall of said vessel not coming into contact with the melt lake (7) and, at the surface of this packed bed (2), a temperature field being generated by means of the coupling in of the thermal power of the flat inductor (4) arranged above the vessel (1) and by means of the heating effect of at least one further inductor (8, 9) arranged outside the vessel (1), said temperature field ensuring the creation of an open and sufficiently deep melt lake (7) at the surface of the coarse-grained packed bed (2), said melt lake being embedded in the unmolten semiconductor material (2).

2. The method according to Claim 1,
**characterised in that**
the granular semiconductor material (2) has a grain size from 0.01 mm to 20 mm.

3. The method according to Claim 1,
**characterised in that**
the central opening (5) of the single-winding disc-shaped inductor (4), in order to pull a crystal (6) of round cross section, likewise has a round cross section.

4. The method according to Claim 1,
**characterised in that**
to pull a round crystal (6), the upper pulling rod (3) rotates with the growing crystal (6) about its axis.

5. The method according to Claim 1,
**characterised in that**
to pull a crystal (6) of rectangular cross section, the central opening (5) in the single-winding disc-shaped inductor (4) likewise has a rectangular cross section.

6. The method according to Claim 1,
**characterised in that**
to pull a crystal (6) of polygonal cross section, the central opening (5) in the single-winding disc-shaped inductor (4) has a similar polygonal cross section.

7. The method according to Claim 1,
**characterised in that**
the high-frequency current that flows through the flat inductor (4) has a frequency between 1 and 4 MHz.

8. The method according to Claim 1,
**characterised in that**
the high-frequency current that flows through the further inductors (8, 9) has a frequency between 5 and 500 kHz.

9. The method according to Claim 1,
**characterised in that**
granular semiconductor material (2) is recharged and melted into the melt lake in accordance with the pulling speed of the single crystal (6), such that the level (H2) of said melt lake in the vessel (1) remains constant.

10. The method according to Claim 1,
**characterised in that**
the vessel (1) rotates with the granular semiconductor material (2) about its axis.

11. A device for producing single crystals from semiconductor material having the material properties of a zone-pulled single crystal by the method according to Claim 1,
**characterised in that**
above a dish-shaped vessel (1), which is filled with granular semiconductor material (2), a flat disc-shaped inductor (4) is arranged, which has a primary slit as current feed and a central opening (5), which corresponds to the desired crystal cross section, through which the single crystal (6) can be drawn upwardly by means of a pulling device (3), and this disc-shaped inductor (4) has an additional opening or recess through which semiconductor material can be refilled via a recharging device (10), and also at least one further inductor (8, 9), which surrounds the vessel (1) externally.

12. The device according to Claim 11,
**characterised in that**
the lateral extent of the flat disc-shaped single-winding inductor (4) exceeds the crystal cross section on all outer edges by more than 20 - 30 mm and is at least 1.5 - 2 times the crystal cross section.

13. The device according to Claim 11,
**characterised in that**
the central opening (5) in the flat disc-shaped single-winding inductor (4) has a shape corresponding to the desired crystal cross section, which makes it possible to pull the crystal through this opening such that contact between the inductor and the crystal or the melt meniscus is avoided.

14. The device according to Claim 11,
**characterised in that**
at least one further inductor (8), which is formed as a coil, is arranged around the vessel.

15. The device according to Claim 11,
**characterised in that**
an additional flat inductor (9) is arranged beneath the vessel.

16. The device according to Claim 11,
**characterised in that**
the vessel (1) consists of an electrically insulating temperature-resistant and abrasion-resistant material.

17. The device according to Claim 16,
**characterised in that**
the vessel (1) consists of quartz glass.

## Revendications

1. Procédé de production de monocristaux à partir de semi-conducteurs, avec les propriétés de matériau d'un monocristal obtenu par tirage par zone flottante, lors duquel on tire le monocristal vers le haut sur un cristal germe hors de la masse fondue qui se trouve sous forme de flaque de matière fondue sur un lit granulaire composé de matériau semi-conducteur, à travers un inducteur plat traversé par un flux HF (un dénommé inducteur Pancake) qui comporte un enroulement et une encoche pour l'alimentation en courant, à travers l'ouverture centrale dudit inducteur,
**caractérisé en ce que**
le matériau semi-conducteur (2) granulaire se trouve dans un récipient (1) perméable aux champs électromagnétiques haute fréquence dont la paroi n'entre pas en contact avec la flaque de masse fondue (7) et **en ce qu'**à la surface dudit lit granulaire (2), par l'injection de puissance thermique de l'inducteur (4) plat disposé au-dessus du récipient (1) et sous l'effet chauffant d'au moins un inducteur (8, 9) supplémentaire qui est disposé à l'extérieur du récipient (1), il est créé un champ de températures qui assure la formation d'une flaque de matière fondue (7) ouverte et suffisamment profonde à la surface du lit granulaire (2) grossier qui est noyé dans du matériau semi-conducteur (2) non fondu.

2. Procédé selon la revendication 1,
**caractérisé en ce que**
le matériau semi-conducteur (2) granulaire présente une grosseur de grains de 0,01 mm à 20 mm.

3. Procédé selon la revendication 1,
**caractérisé en ce que**
pour tirer un cristal (6) à section transversale ronde, l'ouverture centrale (5) de l'inducteur (4) en forme de disque à un seul enroulement présente également une section transversale ronde.

4. Procédé selon la revendication 1,
**caractérisé en ce que**
pour tirer un cristal (6) rond, la broche de tirage (3) supérieure avec le cristal (6) croissant est en rotation autour de son axe.

5. Procédé selon la revendication 1,
**caractérisé en ce que**
pour tirer un cristal (6) à section transversale rectangulaire, l'ouverture centrale (5) de l'inducteur (4) en forme de disque à un seul enroulement présente également une section transversale rectangulaire.

6. Procédé selon la revendication 1,
**caractérisé en ce que**
pour tirer un cristal (6) à section transversale polygonale, l'ouverture centrale (5) de l'inducteur (4) en forme de disque à un seul enroulement présente également une section transversale polygonale.

7. Procédé selon la revendication 1,
**caractérisé en ce que**
le courant haute fréquence, qui circule à travers l'inducteur (4) plat présente une fréquence comprise entre 1 et 4 MHz.

8. Procédé selon la revendication 1,
**caractérisé en ce que**
le courant haute fréquence, qui circule à travers les inducteurs (8, 9) supplémentaires présente une fréquence comprise entre 5 et 500 kHz.

9. Procédé selon la revendication 1,
**caractérisé en ce**
**qu'**en fonction de la vitesse de tirage du monocristal (6), on recharge du matériau semi-conducteur (2) granulaire dans la flaque de masse fondue et on le fait fondre, de telle sorte que le niveau (H2) reste constant dans le récipient (1).

10. Procédé selon la revendication 1,
**caractérisé en ce que**
le récipient (1) avec le matériau semi-conducteur (2) granulaire est en rotation autour de son axe.

11. Dispositif de production de monocristaux à partir de semi-conducteurs, avec les propriétés de matière d'un monocristal obtenu par tirage par zone flottante, à l'aide du procédé selon la revendication 1,
**caractérisé en ce que**
au-dessus d'un récipient (1) en forme d'auge qui reste rempli de matériau semi-conducteur (2) granulaire est disposé un inducteur (4) plat, conçu en forme de disque qui comporte une encoche principale pour l'alimentation du courant et une ouverture centrale (5) qui correspond à la section transversale prévue pour le cristal, à travers laquelle le monocristal (6) peut se tirer vers le haut au moyen d'un dispositif de tirage (3) et **en ce que** ledit inducteur (4) en forme de disque dispose d'une ouverture ou d'un évidement supplémentaire, à travers laquelle ou lequel, par l'intermédiaire d'un dispositif de rechargement (10), on peut rajouter du matériau semi-conducteur et **en ce qu'**au moins un inducteur (8, 9) supplémentaire entoure le récipient (1) par l'extérieur.

12. Dispositif selon la revendication 11,
**caractérisé en ce que**
l'extension latérale de l'inducteur (4) plat à un seul enroulement, conçu en forme de disque dépasse de plus de 20 à 30 mm la section transversale du cristal sur toutes les arêtes extérieures et correspond à au moins 1,5 à 2 fois la section transversale du cristal.

13. Dispositif selon la revendication 11,
**caractérisé en ce que**
l'ouverture centrale (5) de l'inducteur (4) plat à un seul enroulement, conçu en forme de disque présente une forme correspondant à la section transversale souhaitée pour le cristal qui permet de tirer le cristal à travers ladite ouverture, de sorte à éviter un contact entre l'inducteur et le cristal ou le ménisque de la masse fondue.

14. Dispositif selon la revendication 11,
**caractérisé en ce**
**qu'**au moins un inducteur (8) supplémentaire qui est réalisé en tant que bobine est disposé autour du récipient.

15. Dispositif selon la revendication 11,
**caractérisé en ce**
**qu'**un inducteur (9) plat supplémentaire est disposé sous le récipient.

16. Dispositif selon la revendication 11,
**caractérisé en ce que**
le récipient (1) est constitué dans une matière isolante électrique, résistant à la température et à l'abrasion.

17. Dispositif selon la revendication 16,
**caractérisé en ce que**
le récipient (1) est constitué de verre de quartz.
